# EUROPÄISCHE PATENTANMELDUNG

(11) **EP 1 271 719 A2**
(43) Veröffentlichungstag der Anmeldung: **02.01.2003**
(21) Anmeldenummer: 02450109.0
(22) Anmeldetag: 02.05.2002
(51) Int. Cl.: H01R 43/28

(54) **Verfahren und Vorrichtung zum Falten von Flachbandkabeln**

(30) Priorität: 27.06.2001 AT 10022001
(71) Anmelder: I & T Flachleiter Produktions-Ges.m.b.h., 7000 Eisenstadt (AT)
(72) Erfinder: Dragov, Nikola, Dipl.-Ing., 2344 Maria Enzersdorf (AT)
(74) Vertreter: Patentanwälte BARGER, PISO & PARTNER

(57) **Zusammenfassung**

Die Erfindung betrifft ein Verfahren und eine Vorrichtung zum Falten von Flachbandkabeln.

Die Erfindung ist dadurch gekennzeichnet, dass das zu faltende Flachbandkabel (1) mit einem ersten, festes Ende (4) genannten Ende am Falttisch (2) fixiert wird und mit seinem andcrcn, manipuliertes Ende (5) genannten Ende von einer Handhabungsvorrichtung (3) geführt wird, dass die Handhabungsvorrichtung das manipulierte Ende (5) in die Position bringt, die es nach der Faltung haben soll, und dass durch eine Faltvorrichtung, beispielsweise eine Rolle, die in dieser Lage des Flachbandkabels entstandene Schleife (8, 9) glattgestreift wird.

Die Erfindung betrifft auch Ausgestaltungen und eine Vorrichtung zur Durchführung des Verfahrens.

## Beschreibung

Die Erfindung betrifft ein Verfahren und eine Vorrichtung zum Falten von Flachbandkabeln.

Flachbandkabeln sind im Stand der Technik bekannt und werden aus den unterschiedlichsten Gründen zunehmend in der Automobilindustrie bei der Herstellung von Kabelbäumen eingesetzt. Aufgrund der stark anisotropen mechanischen Eigenschaften von Flachbandkabeln können Biegungen und Kurven in der Ebene des Flachbandkabels (und natürlich auch in Ebenen, die nur einen flachen Winkel zu dieser Ebene einschließen) nicht gebogen werden. Dies ist immer dann notwendig, wenn zwischen den beiden Enden des Flachbandkabels (die üblicherweise, aber nicht notwendigerweise mit Steckern versehen sind), eine bestimmte Kontur nachgebildet werden muss.

Dann ist es notwendig, das Flachbandkabel zu falten, wodurch man einen Kabelverlauf bekommt, der im wesentlichen aus einer Abfolge geradlinig verlaufenden Strecken besteht, wobei benachbarte Strecken miteinander durch eine Faltung verbunden sind. Es ist dem Flachbandkabel und dieser Anordnung inhärent, dass die Seite des Flachbandkabels, die (geometrisch gesehen) "vor" der Faltung die Oberseite war "nach" der Faltung die Unterseite ist. Wenn dies, aus welchen Gründen auch immer, nicht zulässig ist, muss statt der Faltung eine Verbindung (z.B. Schweißen) zwischen zwei (zumeist aufeinadergelegten) Kabelabschnitten geschaffen werden.

Bisher hat man derartige Faltungen mit Hilfe von Vorrichtungen durchgeführt, die jeweils an der Stelle, an der ein Flachbandkabel gefaltet werden sollte, entsprechende Anschläge u.dgl. aufweisen. Dies bedeutet, dass bei mehrfach gefalteten Flachbandkabeln, und dies ist die Mehrzahl, da ja die verschiedenen Konturen der Karosserie des Fahrzeuges, in dem der Kabelbaum eingesetzt wird, nachgezogen werden müssen, eine Vielzahl von Faltstationen mit hoher Genauigkeit am Falttisch angeordnet werden müssen. Das bedeutet aber auch, dass selbst bei nur geringen Änderungen in den Abmessungen oder dem Verlauf des Kabelbaumes der gesamte Tisch umgebaut werden muß, was naturgemäß aufwendig und kostspielig ist.

Die Erfindung hat daher das Ziel, ein Verfahren und eine Vorrichtung der eingangs genannten Art zu schaffen, die die genannten Nachteile nicht aufweist und insbesondere kostengünstig für verschiedene Kabelbaumabschnitte aus Flachbandkabeln umrüstbar und einsetzbar ist.

Erfindungsgemäß werden diese Ziele dadurch erreicht, dass das Flachbandkabel mit seinem ersten Ende, bevorzugt bereits mit dem für dieses Ende vorgesehenen Stecker versehen, in eine vorbestimmte Ausgangsposition am Falttisch gebracht und in dieser Position, beispielsweise mittels eines Gegensteckers, eines Niederhalters od.dergl. gehalten wird, dass das andere Ende des Flachbandkabels, ebenfalls bevorzugt bereits mit seinem für dieses Ende vorgesehenen Stecker versehen, von einer Handhabungsvorrichtung gehalten und geführt wird, dass ein Handhabungsautomat die Position und Winkellage dieses Endes des Flachbandkabels feststellt und im Zuge der Bewegung dieses Endes die Lagenänderung feststellt und speichert und dass eine Faltenbildungsvorrichtung, bevorzugt in Form einer Walze oder Rolle mittels eines Handhabungsautomaten in ihrer Höhe über dem Tisch verstellbar und in ihrer Position bezüglich des Tisches ebenfalls verstellbar angeordnet ist, wodurch die Lage der Faltung durch die geometrische Lage der beiden Enden zueinander und bezüglich des Tisches definiert ist und so durch Betätigen der Faltenbildungsvorrichtung die Faltung mit hoher Genauigkeit geschaffen werden kann.
Der Tisch muß nicht eben sein, sondern kann beispielsweise eine Form aufweisen, die es ermöglicht, ein Flachbandkabel so auszubilden, dass es sich der Krümmung eines Dachhimmels, einer Kofferraumhaube, einer Türfüllung od.dgl. sicher anpaßt.
Die erfindungsgemäße Vorgangsweise bei der Schaffung eines entsprechenden Abschnittes eine Kabelbaums aus einem Flachbandkabel ist nun folgender: Das Kabel wird zuerst, wie bereits dargelegt, mit seinem einen Ende an einem vorbestimmten Punkt des Tisches befestigt und wird mit seinem anderen Ende, das manipuliertes Ende" genannt wird, von einer Handhabungsvorrichtung gehalten. Aufgrund der Kenntnis der momentanen Lage des von der Handhabungsvorrichtung gehaltenen manipulierten Endes und der Kenntnis der Endform, die das gefaltete Kabel aufweisen soll, berechnet nun der zum Handhabungsautomaten gehörende Computer die Lage und den Winkel der ersten Faltung. Sodann dreht er das manipulierte Ende des Flachbandkabels so, dass der Übergang von der Oberseite zur Unterseite des Kabels im Bereich der Faltung vorgegeben wird und er bringt das manipulierte Ende des Flachbandkabels in eine Position und Winkellage, in der dieses Ende zu liegen hat, nachdem die erste Faltung durchgeführt ist.

Zur Durchführung bzw. Schaffung dieser Faltung tritt nun die Faltvorrichtung in Aktion, im bevorzugten Fall eine Walze. Diese setzt nahe des manipulierten Endes auf das Flachbandkabel auf und rollt, vom manipulierten Ende weg, auf die Stelle der zu bildenden Faltung hin. Durch diese Bewegung werden sämtliche durch die Steifigkeit des Kabels bewirkte Biegungen und Schlingen geglättet und es entsteht durch die Fixierung des Flachbandkabels in den richtigen Endlagen an der vorbestimmten Stelle und mit dem vorbestimmten Winkel die geplante Faltung.
In der Folge hebt die Faltvorrichtung vom Tisch ab oder bleibt im Faltungsbereich, bevorzugt auf der dem manipulierten Ende des Flachbandkabels abgewandten Seite der Faltung, der Handhabungsautomat bringt das manipulierte Ende des Flachbandkabels in die Lage und Position, die es nach Bildung der zweiten Faltung aufweisen soll und die Faltvorrichtung (oder eine zweite Faltvorrichtung, wenn die erste zum Fixieren der ersten Faltung verwendet wird) bildet erneut, wiederum beginnend im Bereich des manipulierten Endes, mit der Durchführung der Faltung.
Es ist selbstverständlich möglich, zwei oder mehr Faltvorrichtungen vorzusehen, um, insbesondere bei langen und oft zu faltenden Flachbandkabeln, auch die zwischen den Enden liegenden Bereiche während des weiteren Faltens zu fixieren und in der vorbestimmten Lage zu halten.
Wesentlich ist aber, dass die zumindest eine Faltungsvorrichtung nicht wie im Stand der Technik unbeweglich an der für die Faltung vorgesehenen Stelle am Tisch montiert ist, sondern, dass sie, so wie die Handhabungsvorrichtung für das manipulierte Ende, mittels eines Computers und einer entsprechenden elektrischen, pneumatischen oder hydraulischen Antriebsvorrichtung im Bereich des Tisches frei beweglich ist und so durch die Berechnungen des Computers die entsprechenden Bewegungen über den Tisch hin vollführt, um das zwischen dem Tisch und der Faltvorrichtung befindliche Kabel zu falten. Zur Anpassung an Toleranzen aller Art wird die genannte Rolle bevorzugt, auch, weil dabei sichergestellt ist, dass praktisch nur die Kräfte auf das Flachbandkabel übertragen werden, die zur Bildung der Faltung notwendig sind. Es ist selbstverständlich auch möglich, eine Art Klappe od.dgl. vorzusehen, durch die das Flachbandkabel mehr oder weniger gleichzeitig über einen größeren Bereich seiner Länge zur Stelle der gewünschten Faltung hin bewegt und dort gefaltet wird.

Wie aus der Darstellung leicht ersichtlich ist, ist es ein Leichtes mit ein und demselben Tisch ohne Umrüsten die unterschiedlichsten Abschnitte eines aus Flachbandkabeln bestehenden Kabelbaumes zu schaffen, es ist dazu nur notwendig, dass ein anderes Programm in der Datenverarbeitungsanlage für die Handhabungsvorrichtung und die Faltungsvorrichtung aktiviert wird. Bezüglich des mechanischen Ergreifens der Kabelenden ist es ein Leichtes, entweder eine Universalaufnahme für die in Frage kommenden Ausbildungen der Kabelenden zu schaffen oder aber Kupplungsstücke, die einerends mit der Fixierung am Falttisch bzw. mit der Fixierung in der Handhabungsvorrichtung zusammenwirken und andernends mit den jeweiligen Kabelenden, bevorzugt den bereits für die Endmontage vorgesehenen Stecker, zusammenwirken. Auf diese Weise kann durch derartige Zwischenstücke auch dafür Sorge getragen werden, dass die Position der Kabelenden stets richtig erfaßt wird, ohne dass komplizierte Justier- oder Kalibrierschritte unternommen werden müssen, da der Ausgleich kleiner eventueller geometrischer Unterschiede bzw. Abweichungen durch die verwendeten Zwischenstücke erfolgen kann.
Wesentlich ist auch, dass durch das erfindungsgemäße Verfahren die einzelnen Fehler der aufeinanderfolgenden Faltungen sich nicht in eine Richtung addieren können, da bei jeder Faltung das manipulierte Ende des Flachbands mit vorgegebener Genauigkeit an der "richtigen" Stelle gehalten wird, sodass die Fehler der einzelnen Schritte einander immer bestmöglich ausgleichen.
Ein weiterer Vorteil ist, dass es durch das erfindungsgemäße Verfahren möglich wird, eine Faltung sehr dicht an eine bereits bestehende Faltung anzuschließen, da keine am Tisch befestigte Faltvorrichtung den Faltungsvorgang behindert.
Die Erfindung wird im folgenden an Hand der Zeichnung näher erläutert. Dabei zeigt
die Fig. 1 eine rein schematische Draufsicht auf einen erfindungsgemäß ausgestatteten Falttisch,
die Fig. 2 eine rein schematische Seitenansicht auf einen erfindungsgemäß ausgestatteten Falttisch,
die Fig. 3 einen Abschnitt eines idealisierten Flachbandkabels zur Erläuterung der theoretischen Grundlagen der Erfindung,
die Fig. 4 eine weitere Darstellung eines idealisierten Flachbandkabelabschnittes für die Erläuterung der theoretischen Grundlagen der Erfindung,
die Fig. 5 und 6 Besonderheiten zur Berücksichtigung der endlichen Dicke idealer Flachbandkabel und
die Fig. 7 bis 9 erläutern das Vorgehen bei der Bestimmung der Parameter für eine Faltung.

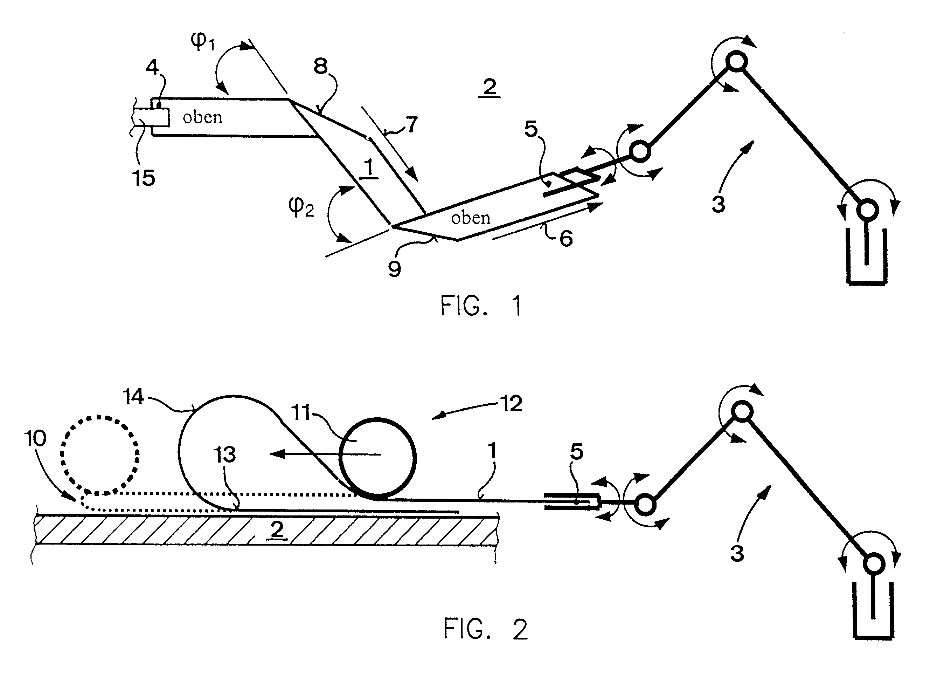

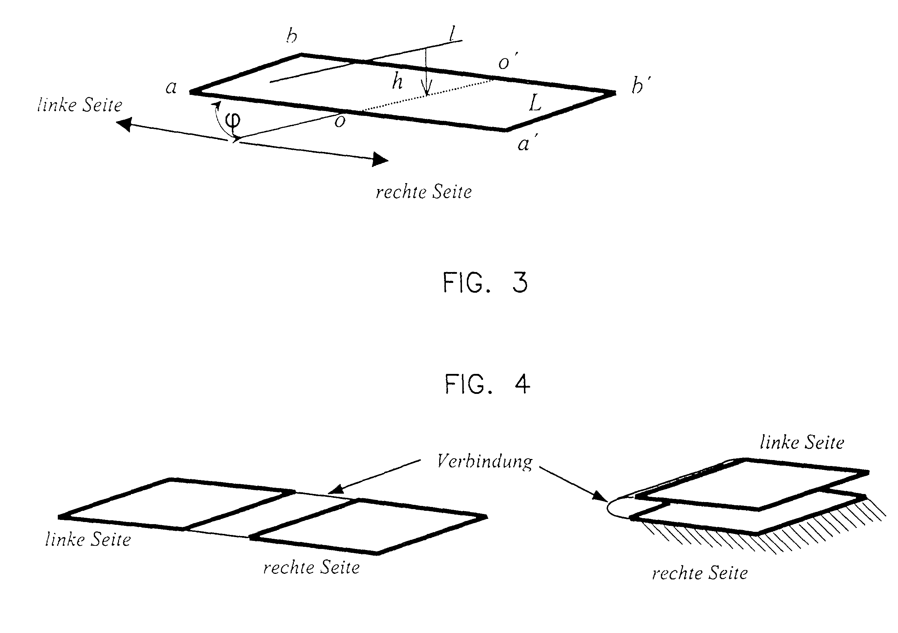

In Fig. 1 ist rein schematisch eine Draufsicht auf einen Falttisch 2 dargestellt und auf dem sich ein Flachbandleiter 1 befindet, der mit seinem einen Ende in einer Haltevorrichtung 15 fixiert ist (fixes oder festes Ende) und der mit seinem anderen Ende von einer Handhabungsvorrichtung 3 erfaßt ist. Dieses von der Handhabungsvorrichtung erfaßte Ende wird im folgenden manipuliertes Ende genannt.
In der Fig. 1 sind durch die Doppelpfeile im Bereich der Handhabungsvorrichtung 3 rein schematisch deren Freiheitsgrade angedeutet, die Pfeile 7 und 6 zeigen die fortschreitende Herstellung des Kabelbaumabschnittes aus dem Flachbandkabel 1 an. Mit ϕ1 und ϕ2 sind die Faltungswinkel angegeben. Es ist auch aus der Fig. 1 ersichtlich und vermerkt, dass die Seite des Flachbandkabels 1, die vom festen Ende 4 die obere Seite ist, nach der ersten Faltung zur unteren Seite wird und nach der zweiten Faltung wiederum zur oberen Seite.
Die Fig. 2 zeigt eine Seitenansicht, teilweise im Schnitt und ebenfalls rein schematisch, wobei der Ablauf der Ausbildung der Faltung ersichtlich wird. Das manipulierte Ende 5 des Flachbandkabels 1 befindet sich in der angegebenen Lage am bzw. knapp oberhalb des Falttisches 2. Das feste Ende des Flachbandkabels 1 ist nicht dargestellt, es ist nur der Bereich dargestellt, der sich, von diesem festen Ende kommend, im Bereich der zu bildenden Faltung 10 befindet. Die Richtung dieses Abschnittes 13 des Flachbandkabels 1 ist, entweder im Falle der ersten Faltung 8 (Fig. 1) durch das feste Ende 4 vorgegeben oder, im Bereich jeder weiteren Faltung 9 (Fig. 1) durch die jeweils unmittelbar vorhergehende Faltung.
Wenn nun das manipulierte Ende 5 sich in der Position befindet, in der es nach erfolgter Schaffung der Faltung 10 sein soll, so ist es durch einfaches Abwalzen bzw. Ausstreifen der durch die beiden Abstand von der kommenden Faltung 10 aufweisenden Flachbandkabelabschnitte, den Abschnitt 13 einerseits und den dem manipulierten Ende 5 benachbarten Abschnitt andererseits, möglich, die Faltung 10 an der richtigen Position des Flachbandkabels 1 zu schaffen, ohne dass am Tisch 2 in diesem Bereich eine feste Faltvorrichtung vorgesehen sein müßte. Die erfindungsgemäß verwendete bewegliche Faltvorrichtung 12 besteht bevorzugt aus einer Walze 11, die auch die Form einer Scheibe od.dgl. haben kann und die, nachdem die Handhabungsvorrichtung 3 das manipulierte Ende 5 in die richtige Position gebracht hat, vom Bereich dieses manipulierten Endes her, das Flachbandkabel 1 aus- oder abwalzt, und so aus der ursprünglichen Schleife 14 die gewünschte Faltung 10 durch Zusammendrücken, herstellt.
Es ist aus dem Zusammenhalt der Fig. 1 und 2 klar ersichtlich, dass es selbstverständlich möglich ist, eine nachfolgende Faltung durchzuführen und dabei eine weitere, nicht dargestellte Faltvorrichtung zu verwenden und die dargestellte Walze 11 in ihrer punktiert eingezeichneten Endlage zu belassen, um besonders bei mehreren nacheinander stattfindenden Faltungen zu verhindern, dass der bereits gefaltete Bereich des Flachbandkabels 1 sich elastisch oder plastisch so deformiert, dass er von der vorgesehenen Endform abweicht. Es ist auch möglich, die gleiche Faltvorrichtung zu verfahren und für die nächste Faltung erneut zu verwenden und dabei die bereits gebildeten Faltung(en) bzw. zumindest deren letzte, durch eine einfache Haltevorrichtung, beispielsweise einen Stempel, zu fixieren.
Es wird in dieser Beschreiung die Faltvorrichtung 12 als Rolle oder Walze oder Scheibe dargestellt und bezeichnet, doch ist es selbstverständlich möglich, statt dessen eine Art Falzmesser zu verwenden, das gleitend über die Schleife 14 geführt wird und sie so zur Faltung bringt. Es ist auch möglich, eine Art Klappe oder Wiege zu verwenden, die um eine Achse verdreht oder entlang einer Bahn verfahren wird und so die Schleife niederdrückt. Die Rolle wird wegen ihres einfachen Aufbaues und der schonenden Behandlung des Flachbandkabels bevorzugt.
Die theoretischen Grundlagen für die Durchführung der Faltung bzw. für die Berechnung und Erstellung der Programme durch die die Handhabungsvorrichtung 3 und die Faltvorrichtung 12 gesteuert werden, ist aus den Fig. 3 bis 9 ersichtlich: Die Fig. 3 zeigt einen Zuschnitt oder auch einen Bereich eines Flachbandkabels, das für die grundlegenden Berechnungen und Bestimmungen des Verfahrensablaufes als flacher, fester Körper mit unendlich kleiner Dicke angesehen wird. Dadurch sind die folgenden geometrischen Abhängigkeiten definiert: a-b // a'-b' a-a' // b-b' und a-o = o-a' b-o' > o'-b'.
Durch o und o' wird eine Linie definiert, die mit der Längskante des Flachbandkabels einen beliebig gewählten Winkel ϕ einschließt. Wenn man nun eine Linie 1 definiert, die im Abstand h parallel zu der von der Flachbandkabeloberfläche definierten Ebene L und genau oberhalb der Punkte o und o' liegt, erhält man das aus Fig. 3 ersichtliche Konstrukt.

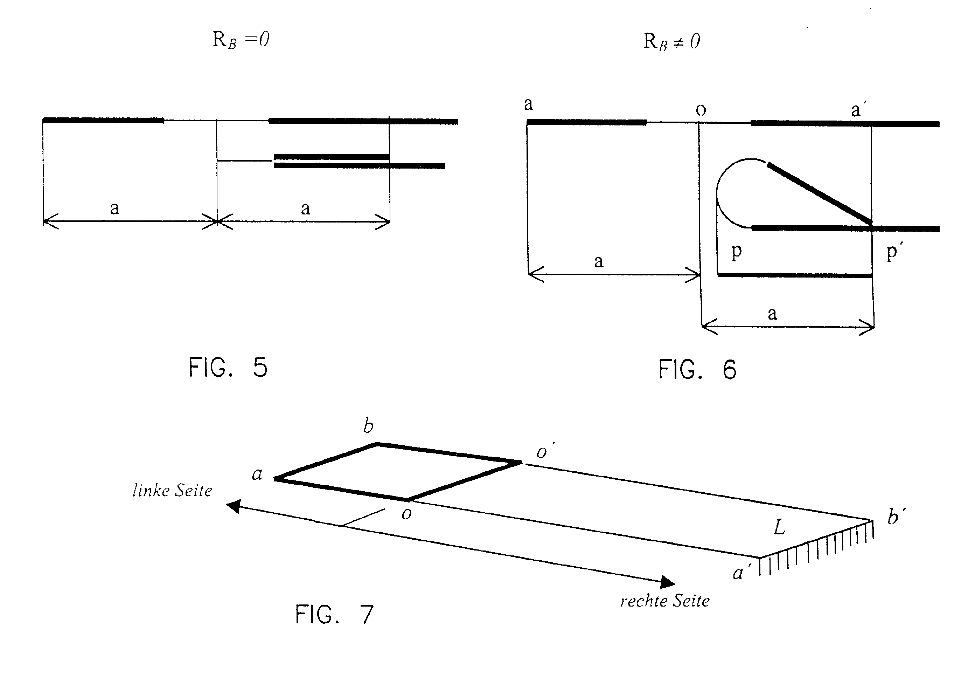

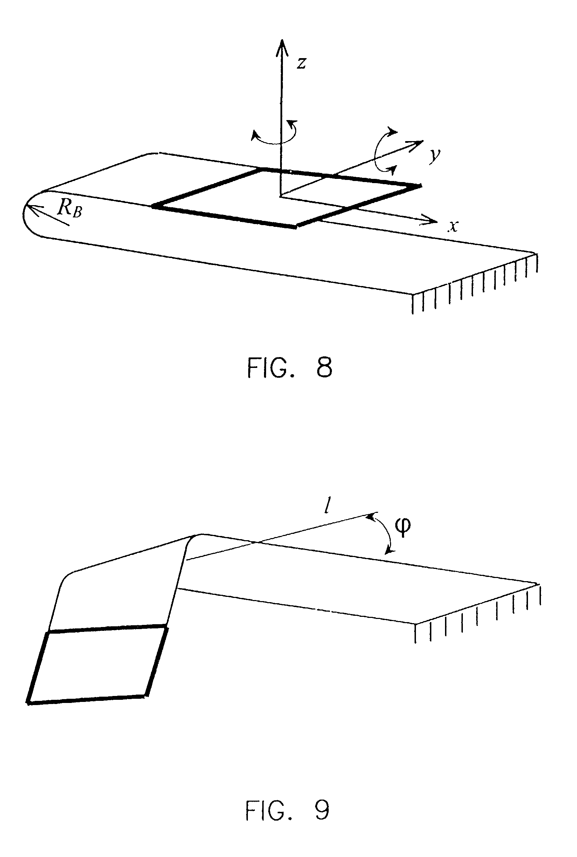

Für die weiteren Betrachtungen geht man davon aus, dass links und rechts der durch die Punkte o, o' gebildeten Linie das Flachbandkabel als plastisch zu betrachten ist, während die weiter weg liegenden Bereiche als starr anzusehen sind. Dies ist in Fig. 4 durch die starken Linien, die die starr gedachten Teile begrenzen und die schwachen Linien, die den als plastisch angesehenen Teil begrenzen, dargestellt.
Als Ganzes hat nun der starre Körper 6 Freiheitsgrade. Wenn man einen der beiden starren Teile einspannt, so bleibt dem anderen noch der durch die plastische Verbindung definierte Freiheitsgrad, nämlich eine Rotation um eine von der plastischen Verbindung bestimmten Achse. Eine solche Biegung bzw. Faltung ist in der rechten Abbildung der Fig. 4 schematisch dargestellt.
Nun ist in realitas aber eine endliche Dicke des Flachbandkabels zu berücksichtigen und daher muss auch dann, wenn man das bisher Ausgeführte auf die Mittelebene des in den meisten Fällen symmetrisch aufgebauten Flachbandkabels bezieht, ein endlicher Krümmungsradius der Faltung zugrundegelegt werden. Die Fig. 5 und 6 zeigen vergleichsweise die aus dem endlichen Radius herrührenden Unterschiede. Diese Unterschiede sind in dem Umfang, in dem sie für die Erfindung relevant sind, eine Verkürzung des Flachbandkabels von der Länge A, wie in Fig. 5 dargestellt, auf die Länge p-p', wie aus Fig. 6 ersichtlich. Es kann dieser Unterschied entweder durch Versuche leicht bestimmt werden oder es werden Berechnungsmethoden verwendet, mit denen dieser Unterschied, der ja aus der Geometrie der Faltung und der plastischen Deformation des Flachbandkabels in diesem, in den Figuren dünn eingezeichneten, Bereich bekannt ist, bestimmt wird.
Eine vollständige Durchführung einer Biegung ist in rein schematischer Schrägansicht aus den Fig. 7, 8 und 9 ersichtlich. Dabei stellt das Ende des Flachbandstreifens mit der Schraffur das feste Ende dar und der mit dicken Strichen umgrenzte Bereich aboo' stellt das manipulierte Ende dar. In Fig. 7 ist die Ausgangslage, aus Gründen der Übersichtlichkeit und da die Skizze ja den theoretischen Erläuterungen dient, ohne Handhabungsvorrichtung dargestellt, die Fig. 8 zeigt die Ausbildung einer Zwischensituation, in der das manipulierte Ende über dem vom festen Ende kommenden Flachbandabschnitt zu liegen kommt und die Fig. 9 schließlich stellt die Endsituation dar, bei dem das manipulierte Ende die gewünschte Endlage einnimmt und das Flachbandkabel um die Biegelinie 1 gebogen ist.
Wie aus dem Gesagten hervorgeht, ist diese Biegelinie 1 nirgendwo am Tisch durch einen Falz od.dgl. materialisiert, sie ergibt sich an der vorbestimmten Stelle durch entsprechende Positionierung des festen Endes und des manipulierten Endes und anschließendes Auswalzen bzw. Glattstreichen bzw. Niederdrücken des Flachbandkabels.
In der Beschreibung wurde immer beschrieben, dass das Auswalzen vom manipulierten Ende her erfolgt. Dies hat seinen Grund darin, dass ja jede Faltung zu einer 180°-Verdrehung des Flachbands um seine Längsachse führt. Diese Verdrehung wird nun vom manipulierten Ende ausgeführt und daher befindet sich die Schleife in diesem Endbereich im Abstand von der Tischoberfläche und kann ausgewalzt werden. In dem Bereich des Flachbands, der dem festen Ende (oder der vorangegangenen Faltung) benachbart ist, befindet sich der Flachband im Kontakt mit dem Tisch oder zumindest in dessen unmittelbarer Umgebung und bedarf keiner plastischen Deformation.

## Patentansprüche

1. Verfahren zum Falten von Flachbandkabeln, **dadurch gekennzeichnet, dass** das zu faltende Flachbandkabel (1) mit einem ersten, festes Ende (4) genannten Ende am Falttisch (2) fixiert wird und mit seinem anderen, manipuliertes Ende (5) genannten Ende von einer Handhabungsvorrichtung (3) geführt wird, dass die Handhabungsvorrichtung (3) das manipulierte Ende (5) in die Position bringt, die es nach der Faltung haben soll, und dass durch eine Faltvorrichtung (11), beispielsweise eine Rolle, die in dieser Lage des Flachbandkabels (1) entstandene Schleife (14) glattgestreift wird.

2. Verfahren zum mehrfachen Falten von Flachbandkabeln nach Anspruch 1, **dadurch gekennzeichnet, dass** nach erfolgter Faltung die Faltvorrichtung (11) aus dem Bereich der Faltung entfernt wird, dass eine Haltevorrichtung, beispielsweise ein Stempel, diese Faltung fixiert, die somit zum festen Ende wird, und dass das Verfahren nach Anspruch 1 wiederholt wird.

3. Vorrichtung zur Durchführung des Verfahrens nach Anspruch 1 oder 2, **dadurch gekennzeichnet, dass** ein Falttisch (2) zumindest eine Fixiervorrichtung (15) für das feste Ende (4) eines Flachbandkabels (1), eine Handhabungsvorrichtung (3) für das manipulierte Ende (5) des Flachbandkabels (1), eine Faltvorrichtung (11) und gegebenenfalls eine Haltevorrichtung aufweist, und dass die Faltvorrichtung (11) und gegebenenfalls die Haltevorrichtung von zumindest einem Handhabungsautomaten bewegbar sind.
